# EUROPEAN PATENT APPLICATION

(11) **EP 3 640 166 A1**
(43) Date of publication of application: **22.04.2020**
(21) Application number: 18200570.2
(22) Date of filing: 16.10.2018
(51) Int. Cl.: B65G 49/05

(54) **METHOD AND INSTALLATION FOR FRAMING A SOLAR PANEL**

(71) Applicant: Mondragon Assembly, S.Coop, 20500 Aretxabaleta (ES)
(72) Inventor: GARCIA ECHEVARRIA, Gorka, 48230 ELORRIO (ES); ERRASTI OCARANZA, Alaitz, 20550 ARETXABALETA (ES); VELASCO UGARTE, Aitzol, 20230 LEGAZPI (ES); ARAGONES REBOLLO, Jose Maria, 20570 BERGARA (ES)
(74) Representative: Igartua, Ismael

(57) **Abstract**

Method and installation for framing a solar panel with a plurality of sides, where a frame is attached to the solar panel. The frame comprises a frame segment for each side of the solar panel, each of said frame segments being attached to the corresponding side. To frame a solar panel, the method comprises in a framing cycle a panel feeding step in which the solar panel to be framed is fed to an attachment station (101) of an installation (1000) configured for framing solar panels, a frame feeding step in which the frame segments for said solar panel are fed to the attachment station (101), and a framing step in which said frame segments are attached to said solar panel.

## Description

### TECHNICAL FIELD

The present invention relates to methods and installations for framing solar panels.

### PRIOR ART

Renewable energy is gaining more importance today compared to fossil energy, and a renewable energy which is on the rise is solar energy. Solar energy is based on converting solar radiation into other forms of energy, such as electrical energy. To that end, solar panels which are exposed to solar radiation and convert said radiation into electrical energy are used.

US9935222B1 discloses a rectangular solar panel. To manufacture the solar panel, a plurality of rows of cells are generated, each row comprising a plurality of cells connected to one another in series. A plurality of rows are then arranged side by side and attached to one another, forming a solar panel. To protect the solar panel, the solar panel is framed in a framing process with four frame segments, a respective frame segment being adhered or attached to each side of the solar panel. Silicone can be used, for example, to adhere the frame segments.

### DISCLOSURE OF THE INVENTION

The object of the invention is to provide a method and an installation for framing solar panels, as defined in the claims.

A first aspect of the invention relates to a method for framing solar panels, in which a frame is attached or adhered to the solar panel. The frame comprises as many frame segments as the sides on the solar panel to be framed, comprising a frame segment for each of said sides, and in the method each of said frame segments is attached or adhered to a respective side of the solar panel.

To frame a solar panel, the method comprises, in a framing cycle:
- a panel feeding step in which the solar panel to be framed is fed to an attachment station,
- a loading step in which the corresponding frame segments for said solar panel are loaded in a loading tool configured for supporting said frame segments and arranged in a loading station,
- a frame feeding step in which movement of the loading tool with said frame segments is caused in a given direction of displacement which is preferably linear, from the loading station where the loading step is implemented to the attachment station, and
- a framing step which is carried out in the attachment station, in which, with a solar panel and the corresponding frame segments arranged in the attachment station, said frame segments are attached or adhered to said solar panel.

With the proposed method, as a result of being able to move the loading tool with respect to the attachment station, once the loading tool is introduced in the attachment station with several frame segments and before the framing of a solar panel with said loading segments ends, the loading tool can be extracted from the attachment station to prepare the frame segments for the next solar panel to be framed. Furthermore, being able to move the loading tool so as to arrange it inside or outside the attachment station where the framing step is performed allows the space that said loading tool occupies, for example, when it is in the attachment station, to be utilized for other tasks, or simply to make the operators' tasks easier, when it is extracted.

A second aspect of the invention relates to a solar panel framing installation which is configured for adhering or attaching a frame to a solar panel. Each solar panel comprises a plurality of sides, and the corresponding frame comprises a frame segment for each side of the solar panel to be framed.

The installation comprises:
- an attachment station where the frame segments are adhered or attached to the corresponding solar panel,
- a loading tool configured for supporting said frame segments and movable between a loading station and the attachment station in a given direction of displacement which is preferably linear, and
- at least one actuation device arranged in the attachment station and configured for moving the frame segments to the corresponding side of the solar panel to be framed arranged in the attachment station.

The advantages mentioned for the first aspect of the invention are likewise also obtained with the installation of the invention.

These and other advantages and features of the invention will become evident in view of the drawings and detailed description of the invention.

### DESCRIPTION OF THE DRAWINGS

Figure 1 shows a rectangular solar panel with a frame, framed according to an embodiment of the method of the invention.
Figure 2 shows an exploded view of the solar panel of Figure 1.
Figure 3 shows an embodiment of a solar panel framing installation according to the invention, configured for framing rectangular solar panels and with a loading tool arranged in the loading station of said installation.
Figure 4 shows the embodiment of Figure 3, with the loading tool loaded with frame segments.
Figure 5 shows an attachment station of the installation of Figure 3, without the release device.
Figure 6 shows the attachment station of Figure 5, with the frame segments and a solar panel.
Figure 7 shows the attachment station of Figure 5, with the frame segments moved to the solar panel.
Figure 8 shows the loading tool of the installation of Figure 3, without a gripping element.
Figure 9 shows a module of the attachment station of Figure 5, with a release device.

### DETAILED DISCLOSURE OF THE INVENTION

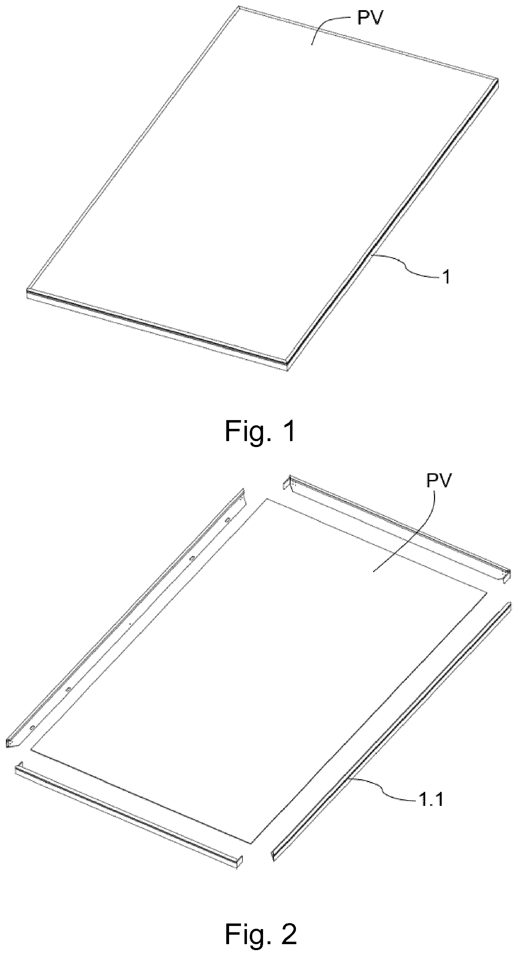

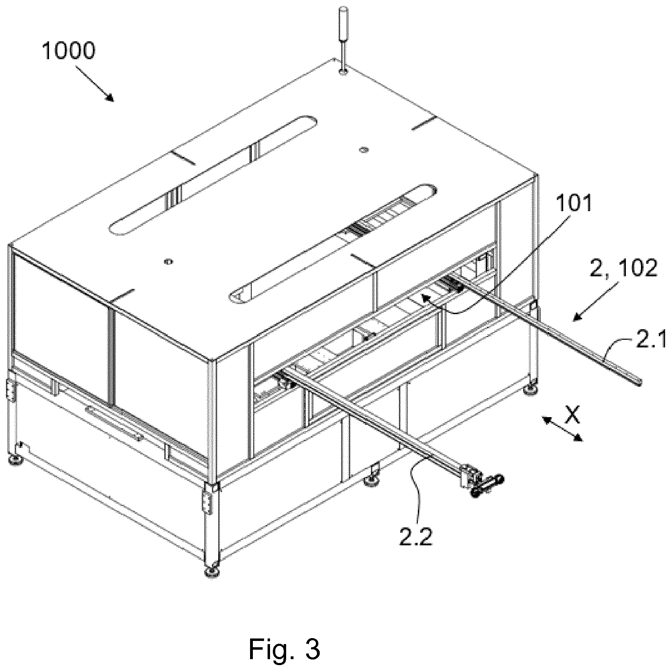

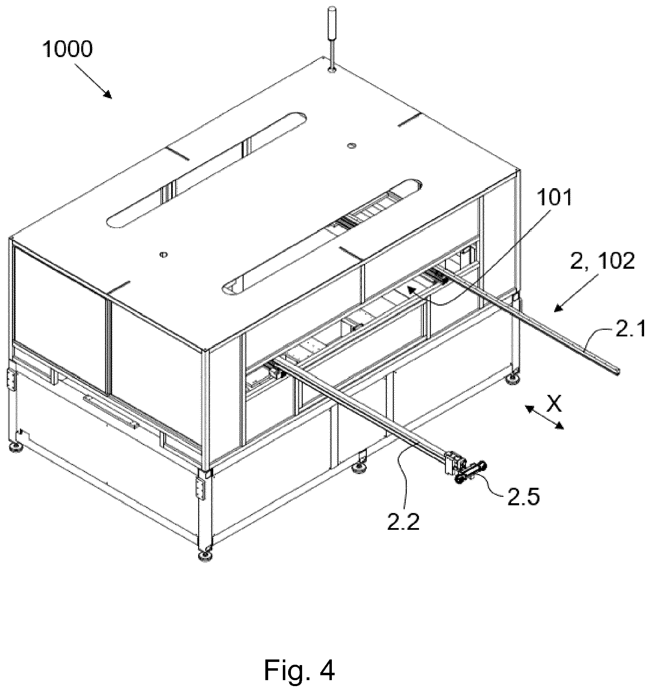

A first aspect of the invention relates to a method for framing a solar panel PV comprising a plurality of sides, with a corresponding frame 1, like the one shown by way of example in Figure 1. The frame 1 comprises as many frame segments 1.1 as there are sides on the solar panel PV to be framed, as depicted in Figure 2, and each of said frame segments 1.1 is adhered or attached to a respective side of the solar panel PV. The solar panel PV is framed in a solar panel framing installation 1000, like the one shown by way of example in Figures 3 and 4.

The frame 1 comprises a plurality of frame segments 1.1, depending on the shape of the solar panel PV (on the number of sides), therefore comprising four frame segments 1.1 if it is a rectangular solar panel PV, and three if it is a triangular solar panel PV, for example. Logically, it would be possible for a solar panel PV to have any shape, although it is preferably a four-sided (rectangular) solar panel PV as shown by way of example in the embodiment of the drawings.

Each of the frame segments 1.1 is attached or adhered to a respective side of the solar panel PV in any of the embodiments of the method. The different frame segments 1.1 can furthermore be attached to one another by means of corner attachment blocks (additional elements with respect to the frame segments 1.1), by means of the shape of the frame segments 1.1 themselves, or by means of any other known method.

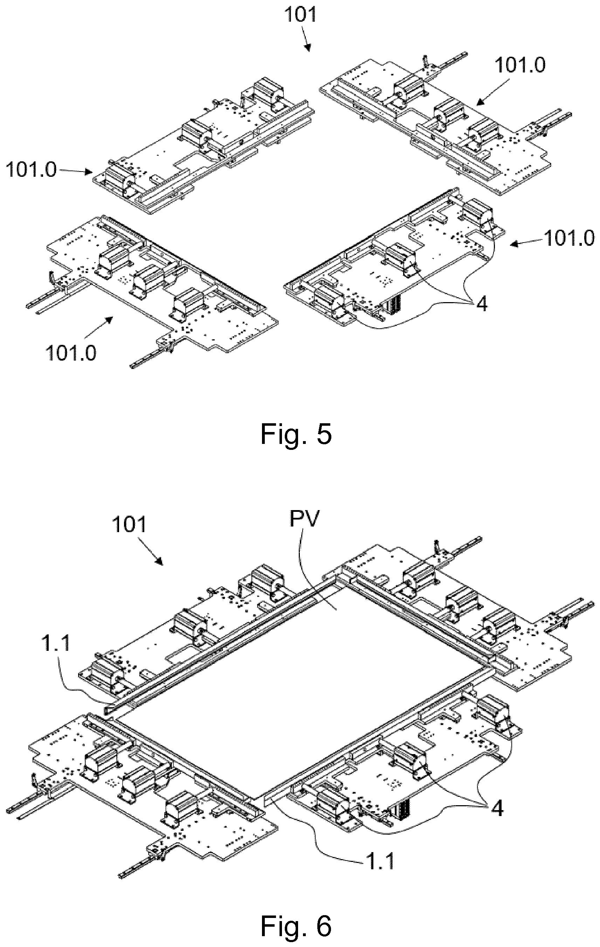

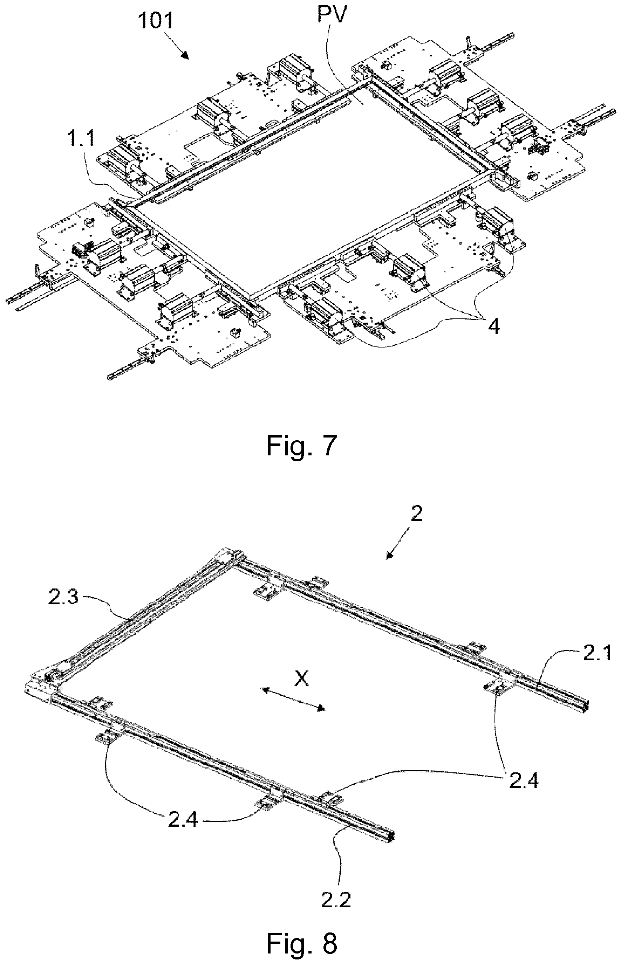

To frame a solar panel PV, the method implements a framing cycle. A framing cycle of the method, in any of its embodiments, comprises at least the following steps:
- a panel feeding step in which the solar panel PV to be framed is fed to an attachment station 101 of the installation 1000, like the one shown by way of example in Figures 5 to 7,
- a loading step which is carried out outside the attachment station 101 (in a loading station 102 of the installation 1000), in which the corresponding frame segments 1.1 for said solar panel PV are loaded in a loading tool 2 configured for supporting said frame segments 1.1 and arranged in the loading station 102, like the one shown by way of example in Figure 8,
- a frame feeding step in which the corresponding frame segments 1.1 for framing said solar panel PV are fed to the attachment station 101, the movement of the loading tool 2 with said frame segments 1.1 being caused to that end in a given direction of displacement X which is preferably linear, from the loading station 102 where the loading step is implemented to the attachment station 101, and
- a framing step which is carried out in the attachment station 101 in which, with a solar panel PV and the corresponding frame segments 1.1 arranged in said attachment station 101, said frame segments 1.1 are attached or adhered to said solar panel PV.

The order in which the steps of a framing cycle have been set forth does not have to coincide with the order in which said steps are carried out as, for example, the panel feeding step does not have to be before the frame loading and feeding steps, for example. However, the frame feeding step must be after the loading step and the framing step must be after the panel feeding step and the frame feeding step.

In a preferred embodiment, the method further comprises a release step which is after the frame feeding step and before the framing step, and which is carried out in the attachment station 101, in which the frame segments 1.1 are released from the loading tool 2. After the release step, the loading tool 2 can therefore already be moved from the attachment station 101 to the loading station 102 once the release step is carried out, so that new frame segments 1.1 are loaded in the loading tool 2, regardless of whether or not a solar panel PV to be framed has been fed, for example, given that once the frame segments 1.1 are released from the loading tool 2, said loading tool 2 no longer takes part in the same framing cycle. This aspect allows making the framing cycle faster compared to the method without the release step, as it is not necessary to wait for there to be a solar panel PV prepared to be framed in the attachment station 102, for example.

In the preferred embodiment, to release the frame segments 1.1 from the loading tool 2 a respective actuation is performed on each of said frame segments 1.1 separating the frame segment 1.1 from said loading tool 2, at least one additional actuation being performed on each of said frame segments 1.1 for attaching or adhering them to the solar panel PV (the framing step). In other embodiments, all the frame segments 1.1 are released from the loading tool 2 with a single actuation, and the framing step is carried out with an additional actuation on each of said frame segments 1.1 (or a single actuation on all the loading segments 1.1).

The loading tool 2 preferably comprises two opposite longitudinal profiles 2.1 and 2.2 separated from one another and configured for supporting the frame segments 1.1, the joint longitudinal movement of both longitudinal profiles 2.1 and 2.2 being caused in the direction of displacement X when the movement of said loading tool 2 (from the loading station 102 to the attachment station 101 and vice versa) is caused. The loading tool 2 preferably comprises an attachment element 2.3 attaching both longitudinal profiles 2.1 and 2.2 to one another, so that both longitudinal profiles 2.1 and 2.2 can move together. Said attachment element 2.3 is preferably a stiff rod extending transversely between both longitudinal profiles 2.1 and 2.2.

When framing rectangular solar panels PV, and as shown in Figure 4, two frame segments 1.1 are arranged in the loading tool 2 longitudinally with respect to the longitudinal profiles 2.1 and 2.2, such that each of said two frame segments 1.1 is supported on or attached to a corresponding longitudinal profile 2.1 and 2.2. The other two frame segments 1.1 are arranged in the loading tool 2 transversely with respect to the longitudinal profiles 2.1 and 2.2, such that each of said two frame segments 1.1 is supported on or attached to both longitudinal profiles 2.1 and 2.2. Preferably, the two frame segments 1.1 which are arranged longitudinally with respect to the longitudinal profiles 2.1 and 2.2 are arranged such that they are supported by or attached to said longitudinal profiles 2.1 and 2.2 with a separation between them that is equal to or greater than the length of the solar panel PV to be framed in the direction transverse to the given direction of displacement X, and the other two frame segments 1.1 are arranged such that they are supported by or attached to the longitudinal profiles 2.1 and 2.2 with a separation between them that is equal to or greater than the length of said solar panel PV in the given direction of displacement X.

Preferably, the frame segments 1.1 which are arranged longitudinally are arranged outside the space existing between the two longitudinal profiles 2.1 and 2.2 of the loading tool 2, such that they leave the entire space between both longitudinal profiles 2.1 and 2.2 free, and the frame segments 1.1 which are arranged transversely, are arranged in said space (between both longitudinal profiles 2.1 and 2.2). This arrangement allows readily arranging all the frame segments 1.1 in the loading tool 2 manually, without an already arranged frame segment 1.1 disturbing during the arrangement of another frame segment 1.1.

In the preferred embodiment, the loading tool 2 is moved manually. To that end, the loading tool 2 may comprise a gripping element 2.5 fixed at one end of at least one of the longitudinal profiles 2.1 and 2.2, and a user grips said gripping element 2.5 and applies a force in the corresponding direction to move said loading tool 2.

A second aspect of the invention relates to a solar panel PV framing installation 1000 which is configured for adhering or attaching a frame 1 to a solar panel PV. The frame 1 comprises a plurality of frame segments 1.1, depending on the shape of the solar panel PV (on the number of sides), therefore comprising four frame segments 1.1 if it is a rectangular solar panel PV, and three if it is a triangular solar panel PV, for example. Logically, it would be possible for a solar panel PV to have any shape, although it is preferably a four-sided (rectangular) solar panel PV as shown by way of example in the embodiment of the drawings.

In any embodiment of the installation 1000, each of the frame segments 1.1 is attached or adhered to a respective side of the solar panel PV. The different frame segments 1.1 can furthermore be attached to one another by means of corner attachment blocks (additional elements with respect to the frame segments 1.1), by means of the shape of the frame segments 1.1 themselves, or by means of any other known method.

The installation 1000 comprises at least, in any of its embodiments:
- an attachment station 101 where the frame segments 1.1 are adhered or attached to the corresponding solar panel PV,
- a loading tool 2 configured for supporting said frame segments 1.1 and movable between a loading station 102 and the attachment station 101 in a given direction of displacement X, said direction of displacement X being preferably linear, and
- at least one actuation device 4 arranged in the attachment station 101 and configured for moving the frame segments 1.1 to the corresponding side of the solar panel PV to be framed arranged in the attachment station 101.

The frame segments 1.1 are loaded or arranged in the loading tool 2, in the loading station 102 of the installation 100, and with said frame segments 1.1 arranged in said loading tool 2, the loading tool 2 moves to the attachment station 101 in the direction of displacement X.

In a preferred embodiment, the attachment station 101 is formed by a plurality of modules 101.0, one for each frame segment 1.1. Each module 101.0 further comprises at least one actuation device 4.

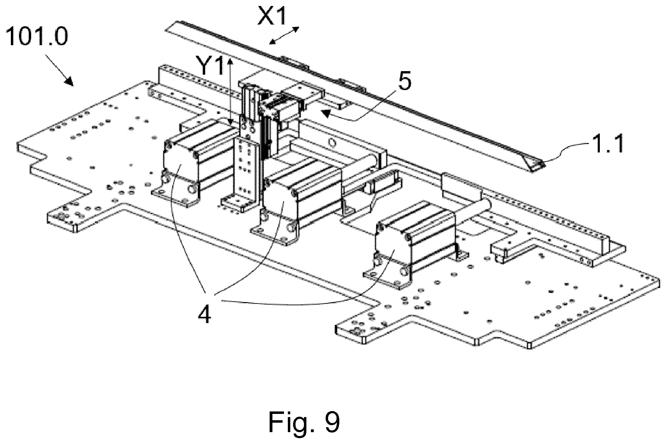

In the preferred embodiment, the installation 1000 comprises a release device 5, shown by way of example in Figure 9, arranged in the attachment station 101. In said preferred embodiment, each module 101.0 of the attachment station 101 comprises at least one release device 5, such that each frame segment 1.1 comprises at least one release device 5. In this case, said actuators can preferably be synchronized to cause a simultaneous actuation thereof. With a simultaneous actuation, the total time required to release all the frame segments 1.1 can be maximally reduced, such that the time required for a framing cycle can be reduced.

The release device 5 is configured for causing a movement of said frame segments 1.1 with respect to the loading tool 2 to a corresponding release position, releasing said frame segments 1.1 from said loading tool 2 for their subsequent adhesion or attachment to the solar panel PV. So, as described for the method, the loading tool 2 is free to move to the loading station 102 to support new frame segments 1.1, speeding up the framing of solar panels PV in the installation 1000. Particularly, the release device 5 can be configured to perform two types of movements: a movement in a horizontal direction X1 and a movement in a vertical direction Y1. The horizontal movement X1 separates the corresponding frame segment 1.1 from the loading tool 2, and the vertical movement Y1 positions said frame segment 1.1 in the actuation area of the actuation device 4.

In the preferred embodiment, the actuation device 4 is configured for moving the corresponding frame segment 1.1 from the corresponding release position (Figure 6) to the corresponding side of the solar panel PV to be framed arranged in the attachment station 101 (Figure 7). In the embodiments in which there is no release device 5, the actuation device 4 itself would be what releases the frame segments 1.1 from the loading tool 2.

Before the actuation device 4 moves the frame segments 1.1 to the solar panel PV, another actuator (not depicted in the drawings) can apply a glue, resin, or similar adhesive on the sides of the solar panels PV to assure proper adhesion or attachment of the frame segments 1.1 to said solar panel PV.

The actuation device 4 may comprise at least one actuator for each frame segment 1.1, like in the case of the embodiment of the drawings (in which three actuators are shown for each frame segment 1.1), or a single actuator for all the frame segments 1.1. In the first case, the actuators associated with the different frame segments 1.1 can be synchronized to cause a simultaneous actuation thereof. With a simultaneous actuation, the total time required for attaching all the frame segments 1.1 to the solar panel PV can be maximally reduced, such that the time required for a framing cycle can be reduced.

In the preferred embodiment, the loading tool 2 comprises two opposite longitudinal profiles 2.1 and 2.2 transversely separated from one another by a given separation distance, and configured for supporting the corresponding frame segments 1.1 on the solar panel PV to be framed. Said longitudinal profiles 2.1 and 2.2 are attached to a structure 101.0 of the attachment station 101 of the installation 1000 with freedom of movement in the given direction of displacement X.

In the preferred embodiment, the installation 1000 comprises an attachment element, not depicted in the drawings, which preferably attaches both longitudinal profiles 2.1 and 2.2 to one another, and can be like the element described for the method.

Each longitudinal profile 2.1 and 2.2 may comprise at least one support 2.4 for supporting the frame segments 1.1. Each longitudinal profile 2.1 and 2.2 preferably comprises two supports 2.4 which are distributed in the direction of displacement X and project from the corresponding longitudinal profile 2.1 and 2.2, preferably out of the space demarcated between both longitudinal profiles 2.1 and 2.2, said two supports 2.4 of a longitudinal profile 2.1 and 2.2 thereby being arranged to support a respective frame segment 1.1 thereon.

Each longitudinal profile 2.1 and 2.2 preferably comprises two additional supports 2.4 which are distributed in the direction of displacement X and project from the corresponding longitudinal profile 2.1 and 2.2 into the space demarcated between both longitudinal profiles 2.1 and 2.2, each additional support 2.4 of a longitudinal profile 2.1 and 2.2 being arranged opposite another additional support 2.4 of the other longitudinal profile 2.1 and 2.2, and said two additional supports 2.4 forming a pair of additional supports 2.4. Each pair of additional supports 2.4 is thereby arranged to support a respective frame segment 1.1.

The installation 1000 is suitable for supporting a method according to the first aspect of the invention, in any of its embodiments and/or configurations, the installation therefore comprising one configuration or another depending on the method that is implemented (or vice versa). The description of the method is therefore also valid for the installation 1000 and vice versa.

## Claims

1. Method for framing a solar panel comprising a plurality of sides, in which a frame (1) is attached or adhered to the solar panel (PV), the frame (1) comprising a plurality of frame segments (1.1) and each of said frame segments (1.1) being attached or adhered to a respective side of the solar panel (PV), **characterized in that** to frame a solar panel (PV), the method comprises, in a framing cycle, a panel feeding step in which the solar panel (PV) to be framed is fed to an attachment station (101), a loading step in which the corresponding frame segments (1.1) for said solar panel (PV) are loaded in a loading tool (2) configured for supporting said frame segments (1.1) and arranged in a loading station (102), a frame feeding step in which movement of the loading tool (2) with said frame segments (1.1) is caused in a given direction of displacement (X) which is preferably linear, from the loading station (102) where the loading step is implemented to the attachment station (101), and a framing step which is carried out in the attachment station (101) in which, with a solar panel (PV) and the corresponding frame segments (1.1) arranged in the attachment station (101), said frame segments (1.1) are attached or adhered to said solar panel (PV).

2. Method according to claim 1, comprising a release step which is carried out in the attachment station (101) after the frame feeding step and before the framing step, in which the frame segments (1.1) are released from the loading tool (2).

3. Method according to claim 2, wherein to release the frame segments (1.1) from the loading tool (2), a respective actuation is performed on each of said frame segments (1.1) separating the frame segment (1.1) from said loading tool (2), at least one additional actuation being performed on each of said frame segments (1.1) for attaching or adhering them to the solar panel (PV).

4. Method according to any of claims 1 to 3, wherein the loading tool (2) comprises two opposite longitudinal profiles (2.1, 2.2) transversely separated from one another and configured for supporting the corresponding frame segments (1.1), the joint longitudinal movement of both longitudinal profiles (2.1, 2.2) being caused in the direction of displacement (X) when the movement of said loading tool (2) is caused.

5. Method according to claim 4, which is suitable for framing rectangular solar panels (PV), with two frame segments (1.1) being arranged longitudinally with respect to the longitudinal profiles (2.1, 2.2), such that each of said two frame segments (1.1) is supported on or attached to a corresponding longitudinal profile (2.1, 2.2), and with two frame segments (1.1) being arranged transversely with respect to the longitudinal profiles (2.1, 2.2), such that each of said two frame segments (1.1) is supported on or attached to both longitudinal profiles (2,1, 2.2).

6. Method according to claim 5, wherein the two frame segments (1.1) which are arranged longitudinally with respect to the longitudinal profiles (2.1, 2.2) are arranged such that they are supported by or attached to said longitudinal profiles (2.1, 2.2) with a separation between them that is equal to or greater than the length of the solar panel (PV) to be framed in the direction transverse to the given direction of displacement (X), and the two frame segments (1.1) which are arranged transversely with respect to the longitudinal profiles (2.1, 2.2) are arranged such that they are supported by or attached to the longitudinal profiles (2.1, 2.2) with a separation between them that is equal to or greater than the length of said solar panel (PV) in the given direction of displacement (X).

7. Method according to claim 5 or 6, wherein the frame segments (1.1) which are arranged longitudinally are arranged outside the space existing between the two longitudinal profiles (2.1, 2.2) of the loading tool (2), one on each side of a respective longitudinal profile (2.1, 2.2), the frame segments (1.1) which are arranged transversely in said space being arranged between both longitudinal profiles (2.1, 2.2).

8. Method according to any of claims 1 to 7, wherein the loading tool (2) is moved manually.

9. Solar panel framing installation configured for adhering or attaching a frame (1) to a solar panel (PV), each solar panel (PV) comprising a plurality of sides and the corresponding frame (1) comprising a frame segment (1.1) for each side of the solar panel (PV) to be framed, **characterized in that** the installation (1000) comprises an attachment station (101) where the frame segments (1.1) are adhered or attached to the corresponding solar panel (PV), a loading tool (2) configured for supporting said frame segments (1.1) and movable between a loading station (102) and the attachment station (101) in a given direction of displacement (X) which is preferably linear, and at least one actuation device (4) arranged in the attachment station (101) and configured for moving the frame segments (1.1) to the corresponding side of the solar panel (PV) to be framed arranged in the attachment station (101).

10. Installation according to claim 9, comprising at least one release device (5) arranged in the attachment station (101), the release device (5) being configured for causing a movement of said frame segments (1.1) with respect to the loading tool (2) to release the frame segments (1.1) from said loading tool (2) to a corresponding release position, for their subsequent adhesion or attachment to the solar panel (PV).

11. Installation according to claim 10, wherein the actuation device (4) is configured for moving the frame segments (1.1) from the corresponding release position to the corresponding side of the solar panel (PV) to be framed arranged in the attachment station (101).

12. Installation according to any of claims 9 to 11, wherein the loading tool (2) comprises two opposite longitudinal profiles (2.1, 2.2) transversely separated from one another by a given separation distance, and configured for supporting the corresponding frame segments (1.1) on the solar panel (PV) to be framed, said longitudinal profiles (2.1, 2.2) being attached to a structure (101.0) of the attachment station (101) with freedom of longitudinal movement in the given direction of displacement (X).

13. Installation according to claim 12, wherein the loading tool (2) comprises an attachment element (2.3) attaching both longitudinal profiles (2.1, 2.2) to one another, such that the longitudinal profiles (2.1, 2.2) are suitable for moving simultaneously and together in the direction of displacement (X), said attachment element (2.3) preferably being a rod extending transversely between both longitudinal profiles (2.1, 2.2).

14. Installation according to claim 12 or 13, wherein each longitudinal profile (2.1, 2.2) comprises at least one support (2.4) for supporting at least one frame segment (1.1).

15. Installation according to claim 14, wherein each longitudinal profile (2.1, 2.2) comprises two supports (2.4) which are distributed in the direction of displacement (X) and project from the corresponding longitudinal profile (2.1, 2.2) out of the space demarcated between both longitudinal profiles (2.1, 2.2), the two supports (2.4) of a longitudinal profile (2.1, 2.2) being configured for supporting a respective frame segment (1.1), and two additional supports (2.4) which are distributed in the direction of displacement (X) and project from the corresponding longitudinal profile (2.1, 2.2) into the space demarcated between both longitudinal profiles (2.1, 2.2), each additional support (2.4) of a longitudinal profile (2.1, 2.2) being arranged opposite another additional support (2.4) of the other longitudinal profile (2.1, 2.2) and said two additional supports (2.4) forming a pair of additional supports (2.4), each pair of additional supports (2.4) being configured for supporting a respective frame segment (1.1).

## Amended claims

### Amended claims in accordance with Rule 137(2) EPC.

1. Method for framing a solar panel comprising a plurality of sides, in which a frame (1) is attached or adhered to the solar panel (PV), the frame (1) comprising a plurality of frame segments (1.1) and each of said frame segments (1.1) being attached or adhered to a respective side of the solar panel (PV), wherein, to frame a solar panel (PV), the method comprises, in a framing cycle, a panel feeding step in which the solar panel (PV) to be framed is fed to an attachment station (101), **characterized in that,** in the framing cycle, the method further comprises a loading step in which the corresponding frame segments (1.1) for said solar panel (PV) are loaded in a loading tool (2) configured for supporting said frame segments (1.1) and arranged in a loading station (102), a frame feeding step in which movement of the loading tool (2) with said frame segments (1.1) is caused in a given direction of displacement (X) which is preferably linear, from the loading station (102) where the loading step is implemented to the attachment station (101), and a framing step which is carried out in the attachment station (101) in which, with a solar panel (PV) and the corresponding frame segments (1.1) arranged in the attachment station (101), said frame segments (1.1) are attached or adhered to said solar panel (PV).

2. Method according to claim 1, comprising a release step which is carried out in the attachment station (101) after the frame feeding step and before the framing step, in which the frame segments (1.1) are released from the loading tool (2).

3. Method according to claim 2, wherein to release the frame segments (1.1) from the loading tool (2), a respective actuation is performed on each of said frame segments (1.1) separating the frame segment (1.1) from said loading tool (2), at least one additional actuation being performed on each of said frame segments (1.1) for attaching or adhering them to the solar panel (PV).

4. Method according to any of claims 1 to 3, wherein the loading tool (2) comprises two opposite longitudinal profiles (2.1, 2.2) transversely separated from one another and configured for supporting the corresponding frame segments (1.1), a joint longitudinal movement of both longitudinal profiles (2.1, 2.2) being caused in the direction of displacement (X) when the movement of said loading tool (2) is caused.

5. Method according to claim 4, which is suitable for framing rectangular solar panels (PV), with two frame segments (1.1) being arranged longitudinally with respect to the longitudinal profiles (2.1, 2.2), such that each of said two frame segments (1.1) is supported on or attached to a corresponding longitudinal profile (2.1, 2.2), and with two frame segments (1.1) being arranged transversely with respect to the longitudinal profiles (2.1, 2.2), such that each of said two frame segments (1.1) is supported on or attached to both longitudinal profiles (2,1, 2.2).

6. Method according to claim 5, wherein the two frame segments (1.1) which are arranged longitudinally with respect to the longitudinal profiles (2.1, 2.2) are arranged such that they are supported by or attached to said longitudinal profiles (2.1, 2.2) with a separation between them that is equal to or greater than the length of the solar panel (PV) to be framed in the direction transverse to the given direction of displacement (X), and the two frame segments (1.1) which are arranged transversely with respect to the longitudinal profiles (2.1, 2.2) are arranged such that they are supported by or attached to the longitudinal profiles (2.1, 2.2) with a separation between them that is equal to or greater than the length of said solar panel (PV) in the given direction of displacement (X).

7. Method according to claim 5 or 6, wherein the frame segments (1.1) which are arranged longitudinally are arranged outside the space existing between the two longitudinal profiles (2.1, 2.2) of the loading tool (2), one on each side of a respective longitudinal profile (2.1, 2.2), the frame segments (1.1) which are arranged transversely in said space being arranged between both longitudinal profiles (2.1, 2.2).

8. Method according to any of claims 1 to 7, wherein the loading tool (2) is moved manually.

9. Solar panel framing installation configured for adhering or attaching a frame (1) to a solar panel (PV), each solar panel (PV) comprising a plurality of sides and the corresponding frame (1) comprising a frame segment (1.1) for each side of the solar panel (PV) to be framed, the installation (1000) comprising an attachment station (101) where the frame segments (1.1) are adhered or attached to the corresponding solar panel (PV), and a loading tool (2) configured for supporting said frame segments (1.1), **characterized in that** the loading tool (2) is movable between a loading station (102) and the attachment station (101) in a given direction of displacement (X) which is preferably linear, the installation (1000) further comprising at least one actuation device (4) arranged in the attachment station (101) and configured for moving the frame segments (1.1) to the corresponding side of the solar panel (PV) to be framed arranged in the attachment station (101) .

10. Installation according to claim 9, comprising at least one release device (5) arranged in the attachment station (101), the release device (5) being configured for causing a movement of said frame segments (1.1) with respect to the loading tool (2) to release the frame segments (1.1) from said loading tool (2) to a corresponding release position, for their subsequent adhesion or attachment to the solar panel (PV).

11. Installation according to claim 10, wherein the actuation device (4) is configured for moving the frame segments (1.1) from the corresponding release position to the corresponding side of the solar panel (PV) to be framed arranged in the attachment station (101).

12. Installation according to any of claims 9 to 11, wherein the loading tool (2) comprises two opposite longitudinal profiles (2.1, 2.2) transversely separated from one another by a given separation distance, and configured for supporting the corresponding frame segments (1.1) on the solar panel (PV) to be framed, said longitudinal profiles (2.1, 2.2) being attached to a structure (101.0) of the attachment station (101) with freedom of longitudinal movement in the given direction of displacement (X).

13. Installation according to claim 12, wherein the loading tool (2) comprises an attachment element (2.3) attaching both longitudinal profiles (2.1, 2.2) to one another, such that the longitudinal profiles (2.1, 2.2) are suitable for moving simultaneously and together in the direction of displacement (X), said attachment element (2.3) preferably being a rod extending transversely between both longitudinal profiles (2.1, 2.2).

14. Installation according to claim 12 or 13, wherein each longitudinal profile (2.1, 2.2) comprises at least one support (2.4) for supporting at least one frame segment (1.1).

15. Installation according to claim 14, wherein each longitudinal profile (2.1, 2.2) comprises two supports (2.4) which are distributed in the direction of displacement (X) and project from the corresponding longitudinal profile (2.1, 2.2) out of the space demarcated between both longitudinal profiles (2.1, 2.2), the two supports (2.4) of a longitudinal profile (2.1, 2.2) being configured for supporting a respective frame segment (1.1), and two additional supports (2.4) which are distributed in the direction of displacement (X) and project from the corresponding longitudinal profile (2.1, 2.2) into the space demarcated between both longitudinal profiles (2.1, 2.2), each additional support (2.4) of a longitudinal profile (2.1, 2.2) being arranged opposite another additional support (2.4) of the other longitudinal profile (2.1, 2.2) and said two additional supports (2.4) forming a pair of additional supports (2.4), each pair of additional supports (2.4) being configured for supporting a respective frame segment (1.1).
